# EUROPEAN PATENT APPLICATION

(11) **EP 2 642 538 A1**
(43) Date of publication of application: **25.09.2013**
(21) Application number: 12160677.6
(22) Date of filing: 22.03.2012
(51) Int. Cl.: H01L 33/24

(54) **3D LED structures**

(71) Applicant: Koninklijke Philips N.V., 5656 AE Eindhoven (NL)
(72) Inventor: De Samber, Marc, A., 5600 AE Eindhoven (NL); Liedenbaum, Coen T. H., 5600 AE Eindhoven (NL)
(74) Representative: Damen, Daniel Martijn

(57) **Abstract**

The present invention provides a light emitting diode (LED) device comprising a p-doped layer (6) and an n-doped layer (5) forming a planar pn-junction (2) and at least one cavity (4). The layers (5, 6) further extend on at least one side wall of at least one cavity (4), thereby forming at least one pn-junction (3) extending in a direction other than the direction of the planar pn-junction (2). Further, the present invention provides a method of producing a LED device comprising the steps of a) providing a growth template comprising at least one cavity, and b) depositing an n-layer and a p-layer on the template such that the layers form a planar pn-junction and the layers further extend on at least one side wall of at least one cavity, thereby forming at least one pn-junction extending in a direction other than the direction of the planar pn-junction.

## Description

### BACKGROUND OF THE INVENTION

Light emitting diodes (LEDs) are increasingly used in different lighting devices. A LED usually consists of a chip of semiconducting layers doped with impurities to create a p-n junction. The layers are generally fabricated by epitaxially growing the doped semiconductor layers on a suitable planar substrate, which may be of different crystal materials. Current may easily flow at the junction from the p-side, or anode, to the n-side, or cathode, and a photon is emitted as a result of an electron-hole pair recombination. The wavelength of the light emitted, and thus its colour, depends on the band gap energy of the materials forming the p-n junction.

The use of LEDs is in many applications preferred instead of using incandescent light sources. The advantages in using LEDs include inter alia a lower energy consumption and a longer lifetime. There is however a need for improving LEDs, e.g. by providing LEDs having an increased lumen output per mm². At the same time, it is desirable to avoid the problem of `droop', which is a fall of efficiency of the LED emission at higher drive currents. Thus, there is a need in the art for providing conventional LEDs with increased lumen output and at the same time avoiding problems that may arise when driving the LED at a high drive current.

A proposed arrangement for increasing the emitted power of a LED is disclosed in US 2010/0314635. This document discloses a chip arrangement comprising a semiconductor which emits electromagnetic radiation and a connection arrangement that allows differently constructed semiconductor chips to be arranged within the same chip arrangement.

### SUMMARY OF THE INVENTION

It is an object of the present invention to provide an improvement of the above techniques and prior art.

The above object is provided according to a first aspect of the invention by a light emitting diode (LED) device comprising a p-doped layer and an n-doped layer forming a planar pn-junction. The device comprises at least one cavity and the layers further extend on at least one side wall of at least one cavity, thereby forming at least one pn-junction extending in a direction other than the direction of the planar pn-junction.

The LED-device of the present disclosure may be any type of LED, such as a Flip Chip type (Thin Film Flip Chip), Patterned Sapphire Substrate, top connected/top emission, top-bottom connected. The LED could be used as naked die, or packaged.

A p-doped layer and an n-doped layer refer to layers that have been p-doped or n-doped, respectively. Thus, the p-doped layer and the n-doped layer may comprise or consist of a semiconductor material. The semiconductor material may be any suitable semiconductor material used for LEDs, such as semiconductors comprising gallium nitride. The p-doped layer may thus form an anode and the n-doped layer may form a cathode. It is to be understood that the LED device may comprise more than one p-doped layer and more than one n-doped layer, respectively.

The p-n junction refers to the boundary between the two doped layers and may for example be formed by epitaxy, i.e. growing one of the doped layers on top of the other doped layers. The p-doped layer and/or the n-doped layer may thus be an epitaxial layer. Further, the p-doped layer and the n-doped layer may have been provided by means of epitaxial growth on a structured template.

The p-doped layer and the n-doped layer may be homogeneous layers, thus forming a single continuous layer structure, or the layers may be inhomogeneous, thereby forming layers in patches. Consequently, the planar pn-junction may be a homogeneous pn-junction and the planar pn-junction and the pn-junction extending on at least a wall of at least one cavity may be connected, thereby forming e.g. a single continuous pn-junction. In other words, the planar pn-junction may extend into the wall of at least one cavity, thereby forming the pn-junction extending in a direction other than the direction of the planar pn-junction. The planar pn-junction may thus be a continuous pn-junction and the other pn-junction, extending in a direction other than the direction of the planar pn-junction, may also be a homogeneous pn-junction.

A cavity refers to a recess and may have any suitable form, such as a cavity having a square shaped opening or a hexagonal shaped opening. Thus, the walls of the cavity do not necessarily have to be perpendicular to the extension of the planar pn-junction. In embodiments of the first aspect, however, all or a part of the pn-junction extending on at least one wall of a cavity is substantially perpendicular to the planar pn-junction. If the p-doped layer and the n-doped layer of the LED extend into at least one cavity, they may thus form three dimensional shaped structures, e.g. 3D-shaped epitaxial layers. The LED device of the present disclosure may further comprise pads connected to the n-doped layer and the p-doped layer, i.e. n-pads and p-pads connected to the cathode and anode. The LED device may also comprise any other transparent coatings, such as an indium tin oxide (ITO, or tin-doped indium oxide) coating. In embodiments, the ITO coating is deposited on the p-doped layer. In other embodiments, the p-doped layer comprises ITO. Thus, an ITO layer may for example form the p-doped layer.

The first aspect of the invention is based on an insight that the light output of the LED may be increased by increasing the effective area for light emission for the LED device. In the LED device, this is realised by the pn-junction extending in more than one direction, such as on the walls of at least one cavity, thereby forming a three-dimensional LED structure, which results in a larger-than-chip effective emission area. The inventors have further found that a three-dimensional LED structure may be formed by growing the p-doped and the n-doped layers on a pre-patterned growing template, such as a pre-patterned sapphire template. Thus, the LED device of the present invention is further advantageous in that it may be easily manufactured by using a pre-patterned growing template. The growing template may in turn be provided by methods used in semiconductor technology, such as cavity etching. As an example, improved etching techniques (Deep Reactive Ion Etching (DRIE) or wet etching in acid at high temperatures) may be used. In other words, the effective emission area of the LED is increased by e.g. depositing (and patterning) the semiconductor layers as epitaxial (epi) in a three-dimensional template which is formed in the sapphire carrier/growth substrate prior to formation of the LEDs. When using a three-dimensional LED structures according to the present disclosure, the effective area for light emission may be dramatically increased compared to the emission of a conventional LED chip with a p-n junction extending in the lateral x-y dimension only. This in turn may provide for an increased light output, either through the effective use of the larger emission area or through driving the LED at a much lower current.

In embodiments of the first aspect, the planar pn-junction may extend on the bottom of at least one cavity.

Thus, the n-doped and p-doped layers may extend on the bottom of at least one cavity. Consequently, the planar pn-junction may both be on the bottom of at least one cavity and between cavities, if the LED comprises more than one cavity.

In embodiments of the first aspect, the device may further comprise a template substrate and the at least one cavity may extend in the direction towards the template sub strate.

This embodiment thus corresponds to the case when a growing template has been used for growing the n-doped and p-doped layers. Consequently, the p-doped layer and/or the n-doped layer may be epitaxial layers and the growing template may thus still be left in the LED-device. In certain embodiments, however, the growing template may have been thinned or fully removed, using e.g. Laser Lift Off, so as to further increase the efficiency of the LED device. The Laser Lift Off may for example also include micro-structuring of an exposed semiconductor layer. As an example, the growing template may comprise sapphire.

However, it is also to be understood that a cavity, such as a cavity in a template substrate, may have additional surface formations of micron/submicron structures, e.g. on the wall of a cavity. This may for example facilitate epi growth of the layers on the template.

Further, surface modification steps, such as structuring and/or further thin film layer deposition, may be used to facilitate epi growth.

In embodiments of the first aspect, the at least one cavity may comprise a plurality of cavities and the layers extend on at least one side wall of at least one of the plurality of cavities.

This is advantageous in that several cavities increase the effective output area further. Such a LED device may have been manufactured by using pre-patterned sapphire as growing template with cavity sizes in the range of ten of microns. Thus, by choosing certain x-y-z aspect ratios of the cavities, which may be a compromise between gained effective emission area and processing, a major area increase can be realized, such as towards 5 x for a 1:1:1 aspect ratio for the cavity in a pre-structured sapphire template.

As an example, the cavities may be about 1-100 µm deep, such as 20-80 µm deep, such as 30-50 µm deep, such as about 40 µm deep. If the cavities are in the range of tens of micrometers, it may facilitate manufacturing of the LED device. For example, if the growing template has cavities that are in the range of tens of micrometers, it allows properly depositing of an epi stack (including the p-doped and n-doped layers) without major problems in defects, as well as depositing and patterning the thin film layers that may be needed for forming and contacting the LED device. Further, the cavities may have approximately the same width as depth.

As a further example, the cavities may be about 1-100 µm wide, such as 20-80 µm wide, such as 30-50 µm wide, such as about 40 µm wide. As a specific example, the cavities may be about 40 x 40 x 40 µm.

If the LED device comprises a plurality of cavities, each cavity and the top structures surrounding the cavity, including e.g. an n-pad and p-pad, may form a unit cell. Consequently, in embodiments of the first aspect, the LED device comprises unit cells connected in parallel as to form a larger area LED.

Further, if the LED device comprises a plurality of cavities, the p-doped layer and the n-doped layer may be arranged such that a planar pn-junction is formed both on the bottom of the cavities and in between cavities. Thus, the n-doped and p-doped layers may extend between cavities and on the bottom of the cavities and on at least one wall of one or several cavities.

In embodiments of the first aspect, the at least one cavity may be a single cavity.

A single cavity, i.e. a coarse feature, may facilitate epi growth of the n-doped and p-doped layer when producing the LED device.

The planar pn-junction may thus extend on the bottom of the single cavity. The single cavity may be elongated, e.g. having the form of a trench. This may further provide for contacting the layers, such as the epi structures, of the device.

As an example, the depth of the single cavity may be about 100-1000 µm, such as about 500-1000 µm. The width of the single cavity may also be about 100-1000 µm, such as about 500-1000 µm.

In embodiments of the first aspect of the invention, the at least one cavity may extend towards an emission area of the device. Further, the p and n contacts of the device may be arranged on the opposite side of the layers as compared to the emission area.

An emission area of the LED refers to an area towards or through which light from the LED is emitted. The cavity or cavities of the LED may thus extend towards the emission area. The emission area may for example be an area of the growing template, such as a sapphire.

The contact pads may thus be the pads that are connected to the anode and cathode of the LED and may used to drive the LED. The contact pads arranged on the opposite side of the semiconductor layers (and hence the pn-junctions) as compared to the emission area may form a mirror structure that enhances the light output of the LED device. A LED device of the present embodiment may thus form a flip-chip type of LED.

Further, the p-n contacts of the LED may also form or be a part of a continuous structure on the opposite side of the layers as compared to the emission area. This is advantageous in that it allows the formation of solder mount contact pads and the formation of a carrier for the semiconductor layers, thus allowing removal of any growth template layer.

Further, if the at least one cavity extends towards an emission area, at least one cavity may be filled with an isolating material. This may thus decrease light output in other directions than via the emission area.

In embodiments of the first aspect, the at least one cavity may extend towards a reflector area. The reflector area may be arranged on the opposite side of the layers as compared to an emission area of the device. The p and n-contacts of the device may be arranged on the same side of the layers as the emission area.

Thus, in this embodiment the contact area of the LED is on the same side as the emission area. The reflector area may for example be arranged on the growth template, e.g. as a reflector or mirror applied on the bottom side of the template, e.g. at the bottom side of a growth sapphire. Thus, in this embodiment, light is not emitted through the sapphire but is instead reflected and emitted on the opposite side of the semiconductor layers. Further, micron/submicron structures may be applied to the reflector area, such as on the growth template or sapphire, to increase out-coupling of the light that is captured in the reflector towards the emission side.

As an example, if the at least one cavity extends towards a reflector area, the at least one cavity may be filled with an optical enhancement material.

This may further increase the light output of the LED device.

Further, the optical enhancement material may be a 'color conversion fill', such as a phosphorescent material. This may further help to maintain the etendue of the lateral emission area.

Further, if the LED device comprises a plurality of cavities, the cavities may be filled with different materials. As an example, certain cavities may be filled with a first type of phosphor (e.g. converting blue to white) and other cavities (on the same LED) may be filled with another type of phosphor (e.g. converting blue to red).

In embodiments of the first aspect, a wall of at least one cavity may be substantially perpendicular to the planar pn-junction such that the at least one pn-junction extending in a direction other than the direction of the planar pn-junction is substantially perpendicular to the planar pn-junction.

However, the walls of a cavity may extend in any suitable direction compared to the planar pn-junction, i.e. the other pn-junction and the planar pn-junction do not have to extend in perpendicular directions.

Consequently, a wall of at least one cavity may be arranged at an angle that is not substantially perpendicular to the planar pn-junction, such that the at least one pn-junction extending in a direction other than the direction of the planar pn-junction is not perpendicular to the planar pn-junction.

This may be advantageous e.g. during build up of epi layers on a substrate template. Thus, "slanting" walls of a cavity may facilitate epi growth of the semiconductor layers.

As a second aspect of the invention, there is provided a method of producing a LED device comprising the steps of
a) providing a growth template comprising at least one cavity, and
b) providing an n-layer and a p-layer on the template such that the layers form a planar pn-junction and the layers extend on at least one side wall of at least one cavity, thereby forming a pn-junction extending in a direction other than the direction of the planar pn-junction.

The terms and definitions used in the second aspect of the invention are the same as discussed in relation to the other aspects of the invention above. In analogy with the first aspect of the invention above, a method according to the second aspect provides a LED device having increased light output capabilities. The second aspect of the invention is also advantageous in that it provides for a simple and straight-forward method of manufacturing such a three-dimensional LED-structure.

It will be appreciated that the features of the embodiments described with reference to the first aspect of the invention are also combinable with the method as defined in accordance with the second aspect of the invention.

The growth template may for example be a sapphire growth template.

In embodiments of the second aspect of the invention, step a) may comprise etching a growth template to provide the growth template comprising at least one cavity.

Etching may for example be wet or dry etching or any suitable type of etching that is used in semiconductor technology. Different etching thus provides for a variety of cavity sizes and dimensions.

In embodiments of the second aspect of the invention, step b) may comprise providing of the layers such that the planar pn-junction is formed on the bottom of the cavities and/or on the top surface of the template.

Thus, the planar pn-junction may be formed both on the bottom of the cavities and between cavities, if a plurality of cavities are to be used.

In embodiments of the second aspect, the method is further comprising a step c) of removing, partially or completely, the growth template. This may increase the functionality of the LED device. Removing the growth template may for example be achieved by Laser Lift Off.

In embodiments of the second aspect, the method may further comprise a step of forming a second substrate on the semiconductor layers that is on the opposite side of the pn-junction compared to the growth template. This second substrate may for example comprise the n- and p-pads. This step may be performed before or after step c) above. Such a second substrate may allow for removal of the initial growth template. The second substrate may form a contact area of the LED device.

The method may also include steps of forming n-and p-pads on the n-and p-doped layer, respectively.

Further features of, and advantages with, the present invention will become apparent when studying the appended claims and the following description. Those skilled in the art realize that different features of the present invention can be combined to create embodiments other than those explicitly described in the following.

### BRIEF DESCRIPTION OF THE DRAWINGS

The aspects of the present invention will now be described in more detail, with reference to the appended drawings showing currently preferred embodiments of the invention.
Fig. 1 shows a three dimensional LED unit cell that forms the individual LED functionality of a LED device;
Fig. 2 shows an overall LED device structure with a plurality of cavities, in which the cavities are facing the emission area;
Fig. 3 shows the LED device of Fig. 2, further comprising a SMD contact pad area;
Fig. 4 shows an overall LED device structure with a single cavity, in which the cavity is facing the emission area;
Fig. 5 shows an overall LED device structure with a plurality of cavities, in which the cavities are facing a reflective layer; and
Fig. 6 shows an overall LED device structure with a single cavity, in which the cavity is facing a reflective layer.

### DETAILED DESCRIPTION

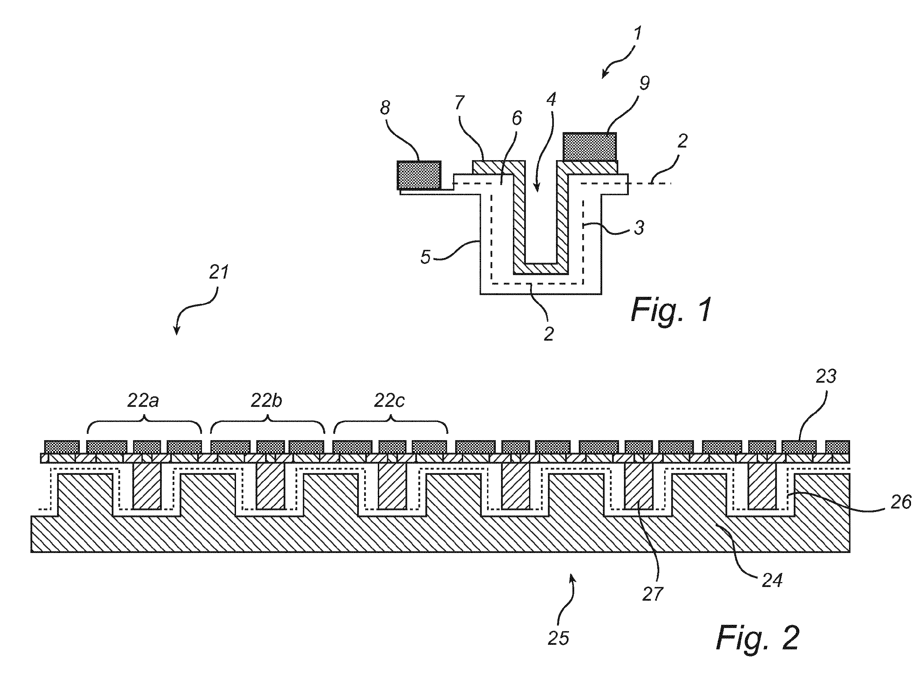

Fig. 1 shows a three dimensional LED unit cell 1 that forms the individual LED functionality of a LED device. The unit cell 1 comprises a cavity 4 formed by the n-doped layer 5 and the p-doped layer 6. The unit cell 1 thus has a planar pn-junction 2 and a pn-junction 3 on the walls of the cavity 4. The unit cell further comprises an ITO-layer 7 (Indium Tin Oxide), deposited on top of the p-doped layer, as well as a n-pad 8, an electrode connected to the n-doped semiconductor (forming a cathode) and a p-pad 7, an electrode connected to the p-doped semiconductor layer (forming an anode). Thus, a unit cell of Fig. 1 has an increased light emitting area compared to a device with only a planar pn-junction.

Even if the side wall of the cavity is more or less illustrated in Fig. 1 as perpendicular to the top surface, the side wall of a cavity do not necessarily have to be straight (90° angle). These side walls could have other shapes, depending on the combination of etching technology and linked to the requirements of epi growth and thin film processing.

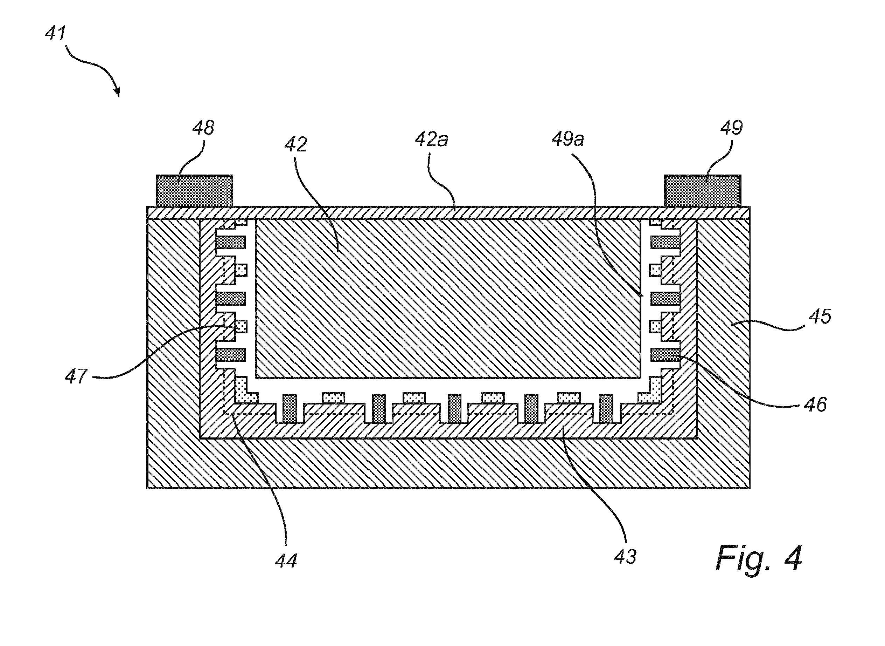

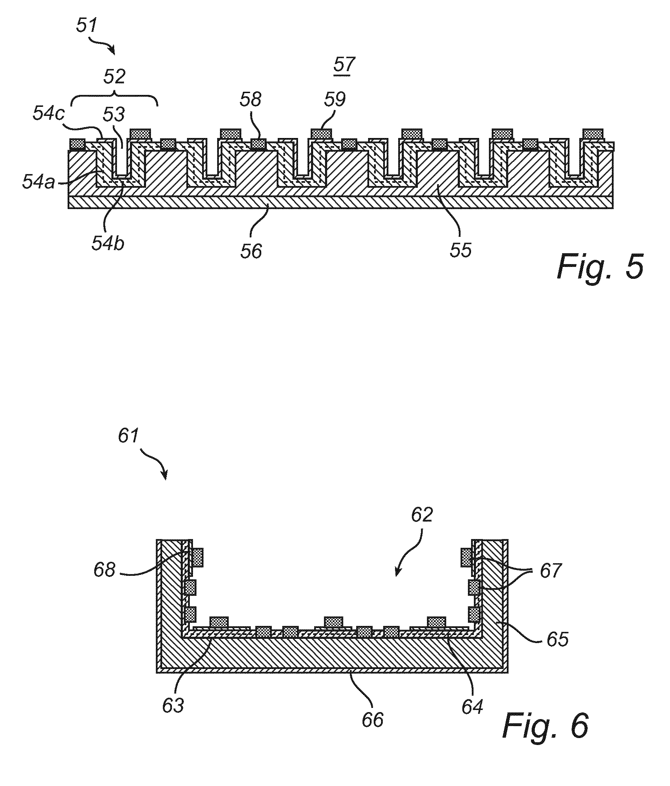

Other dimensional options are, next to a square cavity, e.g. hexagonal (or other) x-y shapes, or elongated cavities. Elongated cavities (in the form of e.g. a trench) might sacrifice some of the gained surface area but might be much easier for contacting the n- and p-doped layers. Such elongated cavities may be used in the embodiments with a single cavity, such as the embodiments shown in Figs. 4 and 6.

Fig. 2 shows an overall construction with unit cells connected in parallel as to form a larger area LED device 21. Hence, the LED device 21 of Fig. 2 is a structure with a plurality of cavities 27, in which the cavities are facing the emission area 25. The device 21 comprises a plurality of unit cells 22a, 22b, 22c, i.e. unit cells similar to the unit cell 1 shown in Fig. 1. The device 21 has been manufactured by growing the epitaxial semiconductor layers on a structured sapphire template 24. As seen in Fig. 2, the pn-junction 26 extends into the cavities, thus forming a planar pn-junction between the cavities and pn-junctions that are substantially perpendicular to the planar pn-junction. In this embodiment, the pn-junctions form a single continuous pn-junction that extend both between cavities and within the cavities, i.e. the walls and on the bottom of the cavities. The p-and n-pads of the device 21 are positioned on the opposite side of the pn-junction as compared to the emission area 25, and form together a contact area 23. The contact area 23 may be reflective so as to increase the light output from the emission area 25. Thus, in this embodiment the LED device 21 is composed of multiple 3D LED unit cells, each forming an individual LED functionality. For such case the cavity size may be in the range of some tens of microns (e.g. 40 x 40 x 40 µm) so as to allow properly depositing the epi stack and depositing and patterning the thin film layers that may be needed for forming and contacting the LED device.

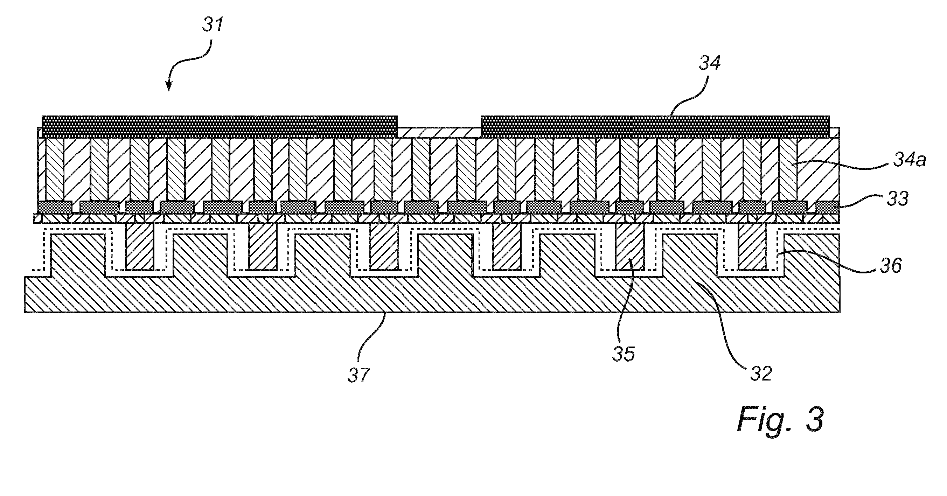

Fig. 3 shows the LED device of Fig. 2 further comprising a Surface Mount Device (SMD) contact pad area 34. In this embodiment, the earlier multi-cavity 3D LED structure 31, comprising the cavities 35, pn-junction 36 and emission area 37, is further processed as to realize a wafer level Chip Size Package (CSP) construction. The main reasons to do so may be to form Solder Mount contact pads in the contact pad area 34 or to form a 'new' carrier that would allow removing the sapphire carrier/template 32. The contact area 34 is connected to the individual p-and n-pads 33 e.g. by means of connections 34a, but any required re-routing layout that allows connecting the multiple p- and n-contacts towards overall combined pads of the layer 34 is not further elucidated in this drawing.

As an alternative, such wafer level CSP components might also be formed by bonding the LED wafer to a new carrier wafer, connecting during this bonding process the initial electrical pads to pads on the carrier wafer, including through wafer vias and (if required) additional re-routing layers as to re-route towards SMD compatible solder pads. Next the original carrier/template wafer (sapphire) can be removed (and possibly be re-used).

Fig. 4 shows an overall LED device 41 structure with a single cavity 42, in which the cavity is facing the emission area (not depicted). The epitaxial stack 43 of the n-doped and p-doped layers is formed on both the bottom of the cavity 42 and on the walls of the cavity 42. The device 41 as shown in Fig. 3 has been manufactured by epitaxial growth on a sapphire template 45 having a single cavity. The single cavity 42 extends towards an emission area (not shown) and may be filled with an isolating material to further increase the light output in the direction of the extension of the cavity 42. Further, the cavity has a bottom isolator 42a as a "lid" over the cavity 42, to even further direct the light towards the emission area, i.e. through the bottom of the cavity 42.

The pn-junction 44 extends both on the bottom of the cavity, thereby forming a planar pn-junction, and on the walls of the cavity, thereby forming a pn-junction that is substantially perpendicular to the planar pn-junction. The device 41 comprises several n-contacts 46 and p-contacts 47 formed in the epi stack, as well as an anode contact area 48 and a cathode contact area 49. However, any reflector and rerouting layers 49a required to contact the large area of the LED, thereby contacting the numerous p- and n-contact points, are not shown in detail for clarity reasons. Thus, in this embodiment of Fig. 4, the LED device 41 is based on a single, deep cavity 42 pre-structured in the sapphire carrier wafer 45. Depth could be e.g. > 0.5 mm and up to 1 mm for a LED die of 1 x 1 mm². The coarser features of the single cavity may facilitate epi growth.

Fig. 5 shows an overall LED device structure 51 with a plurality of cavities, exemplified by 53. In analogy with the embodiment shown in Fig. 2, the device 51 comprises a plurality of "unit cells" 52, connected in parallel. The unit cells each comprise a cavity 53 in which the epi layers form pn-junctions 54a, 54b both on the bottom of the cavity (54b) and on the walls of the cavity (54a), as well as in between the cavities, thereby forming a continuous pn-junction. The cavities 53 are facing a reflective layer 56, which means that the emission area 57 of the LED device 51 is located on the opposite side of the pn-junction 54a, 54b compared to the embodiment shown in Fig. 2, i.e. on the opposite side of the pn-junction 54a, 54b compared to the reflective layer 56. The reflective layer 56 may thus act as a heat sink. The n-contact pads 58 and the p-contact pads 59 are located on the same side of the pn-junction as the emission area 57. In other words, in the configuration of Fig 5, the contact area is on the same side as the emission area 57 and the light is not emitted on or through the sapphire substrate 55, but the sapphire substrate 55 serves as reflector body, e.g. by means of the reflector/mirror layer 56 applied on the bottom side of the sapphire substrate 55. Further, micron/submicron structures in the reflector layer 56 may be applied to increase out-coupling of the light that is captured in the sapphire substrate 55 again towards the epi side, i.e. the emission side 57.

Fig. 6 shows a LED device structure 61 with a single cavity 62, in which the cavity 62 is facing a reflective layer 66. In this embodiment the LED is thus based on a single, deep cavity pre-structured in the sapphire carrier wafer 65. Depth could be e.g. > 0.5 mm and up to 1 mm for a LED die of about 1x1 mm². As in the embodiment shown in Fig. 4, the pn-junctions 64 extend both on the bottom of the cavity 62 and on the walls of the cavity 62. The reflector layer 66 is located below the growth sapphire 65, i.e. the cavity 62 extends towards this reflector area 66. The device 61 may further comprise an ITO transparent electrode 68. However, other transparent while electrically conductive layers are also possible, such as Indium Zinc Oxide (IZO).

In analogy with the embodiment of Fig. 4, the device 61 further comprises a number of contact pads 67 that are connected to the p-doped layer and the n-doped layer. However, for clarity reasons the measures to connect (re-route) all individual contact point are not shown. As for the case of 'planar' devices of this type, typically the contact pads 67 would be connected using narrow metal lines, so as to limit the shadowing/shielding in the light emission. Further, the cavity 62 may be filled with optical enhancement features, such as e.g. optical out coupling material. Alternatively or additionally, the cavity 62 may be filled with a color (or wavelength) conversion material, such as a phosphorescent material. Also this cavity structure is very suitable for being used as the template or reflector cup to beam shaping. In such case the electrical contacts may have to be redistributed such that these are still accessible for next level contacting.

Even though the invention has been described with reference to specific exemplifying embodiments thereof, many different alterations, modifications and the like will become apparent for those skilled in the art. The described embodiments are therefore not intended to limit the scope of the invention, as defined by the appended claims.

## Claims

1. A light emitting diode, LED, device (21) comprising
- a p-doped layer (6) and an n-doped layer (5) forming a planar pn-junction (2); and
- at least one cavity (4);
wherein said layers further extend on at least one side wall of at least one cavity (4), thereby forming at least one pn-junction (3) extending in a direction other than the direction of the planar pn-junction (2).

2. A LED device according to claim 1, wherein the planar pn-junction extends on the bottom of at least one cavity.

3. A LED device according to claim 1 or 2, further comprising a template substrate (24) and wherein said at least one cavity extends in a direction towards said template substrate (24).

4. A LED device according to any previous claim, wherein the at least one cavity comprises a plurality of cavities and said layers extends on at least one side wall of at least one of said plurality of cavities.

5. A LED device according to claim 4, wherein the cavities are about 1-100 µm deep.

6. A LED device according to any one of claims 1-3, wherein the at least one cavity is a single cavity (42).

7. A LED device according to claim 6, wherein the depth of said single cavity is about 100-1000 µm.

8. A LED device according to any previous claim, wherein the at least one cavity extends towards an emission area of the device and wherein the p and n contacts (7, 8) of the device are arranged on the opposite side of said layers as compared to said emission area.

9. A LED device according to claim 8, wherein at least one cavity is filled with an isolating material.

10. A LED device according to any one of claims 1-7, wherein the at least one cavity extends towards a reflector area (56), wherein said reflector area (56) is arranged on the opposite side of said layers as compared to an emission area of the device, and wherein the p and n contacts of the device are arranged on the same side of said layers as the emission area.

11. A LED device according to claim 10, wherein at least one cavity is filled with an optical enhancement material.

12. A LED device according to any previous claim, wherein a wall of at least one cavity is substantially perpendicular to said planar pn-junction such that at least one pn-junction extending in a direction other than the direction of the planar pn-junction is substantially perpendicular to said planar pn-junction.

13. A method of producing a LED device comprising the steps of
a) providing a growth template (24) comprising at least one cavity, and
b) providing an n-layer and a p-layer on said template such that said layers form a planar pn-junction and said layers further extend on at least one side wall of at least one cavity, thereby forming at least one pn-junction extending in a direction other than the direction of the planar pn-junction.

14. A method according to claim 13, wherein step a) comprises etching a growth template to provide said growth template comprising at least one cavity,

15. A method according to claim 13 or 14, wherein step b) comprises providing of the layers such that the planar pn-junction is formed on the bottom of said cavities and/or on the top surface of said growth template.
